(19) Europäisches Patentamt
European Patent Office
Office européen des brevets

(11) **EP 1 531 190 A1**

(12) **EUROPEAN PATENT APPLICATION**

(43) Date of publication:
**18.05.2005 Bulletin 2005/20**

(51) Int Cl.7: **C23C 16/44**, B01D 53/68

(21) Application number: **04256984.8**

(22) Date of filing: **11.11.2004**

(84) Designated Contracting States:
**AT BE BG CH CY CZ DE DK EE ES FI FR GB GR HU IE IS IT LI LU MC NL PL PT RO SE SI SK TR**
Designated Extension States:
**AL HR LT LV MK YU**

(30) Priority: **12.11.2003 US 519203 P**
**26.03.2004 US 556912 P**
**10.11.2004 US 985355**

(71) Applicant: **THE BOC GROUP, INC.**
**Murray Hill, New Providence,**
**New Jersey 07974 (US)**

(72) Inventor: **Satchell, Donald Prentice**
**Chatham, New Jersey 07928 (US)**

(74) Representative: **Booth, Andrew Steven et al**
**The BOC Group plc,**
**Chertsey Road**
**Windlesham, Surrey GU20 6HJ (GB)**

(54) **Method of treating a gas output from a processing chamber**

(57)    A method for selecting, using, regenerating, and recycling fluorochemicals for plasma cleaning and etching steps for semiconductor device production is provided. This method comprises selection of a regenerable fluorochemical, using the regenerable fluorochemical working fluid for chamber cleaning or etching, and regenerating the fluorochemical working fluid with sequential fluorination and defluorination steps. This invention allows the efficient use of the most cost-effective and safe chamber cleaning gases without adversely affecting the environment.

*FIG. 1*

**EP 1 531 190 A1**

**Description**

The present invention relates to a method of treating a gas output from a processing chamber. The method can be used to increase cleaning and etching gas utilization in the production of semiconductor electronic devices and thin film transistor liquid crystal display devices

Production processes for semiconductor electronic devices and thin film transistor liquid crystal display devices generally use gaseous fluorochemicals, such as nitrogen trifluoride ($NF_3$), sulfur hexafluoride ($SF_6$) and carbon tetrafluoride ($CF_4$), as etchants and chamber cleaning gases. In etching production steps, silicon is removed from the semiconductor device by reaction with fluorine from the gaseous fluorochemicals to produce primarily $SiF_4$. In chamber cleaning steps, the deposits on the wall of the process chamber are removed by reaction with fluorine from the gaseous fluorochemical to produce predominately $SiF_4$, HF, and $CF_4$ from the silicon, hydrogen, and carbon atoms in the debris on the process chamber wall. The consumption of these gases within the process chamber is typically low, usually less than twenty percent. Typically, combustion with a hydrocarbon fuel has been used to convert the fluorine atoms within the fluorochemical species that are present in the effluent stream from the process chamber cleaning and etching process steps to HF. There are two primary problems with this approach. First, the HF product from a conventional hydrocarbon combustion processes is not appropriate for recycle to perform silicon etching or chamber cleaning processes. Therefore, the semiconductor processes typically usefully utilize only a small fraction of the etching and cleaning gas feed and the balance creates a significant waste disposal problem. Second, the available combustion exhaust abatement systems typically achieve incomplete conversion and recovery of the most stable fluorochemical gases, particularly $SF_6$ and $CF_4$. As a result, a substantial portion of the original fluorochemical feed gas can ultimately be discharged to the atmosphere. These very stable fluorochemical etching and chamber cleaning gases have long persistence in the atmosphere, very effectively absorb infrared radiation, and, as a result, have a disproportionately large contribution to the global warming problem. As a result, the semiconductor industry has sought ways to diminish the impact of chamber cleaning and etching gas emissions.

Three general strategies have emerged to decrease global warming gas emissions in the semiconductor industry. First, innovative approaches have been proposed to use fluorochemicals that have much lower persistence in the atmosphere and, therefore, much lower global warming potential. For example, United States Application 2003/0010354 teaches a chamber cleaning method that utilizes molecular fluorine to avoid the use of fluorochemical gases having higher global warming potential like $NF_3$, $CF_4$, $C_2F_6$, and $SF_6$. One disadvantage of this approach is that fluorochemical gases with the lowest global warming potential, $F_2$ and $ClF_3$ for example, are generally very reactive and toxic, thus adversely effecting plant safety.

Second, the industry has sought to develop more effective exhaust abatement technology. For example, United States Patent 5,965,786 teaches a method of using atmospheric pressure plasma to destroy unused perfluorinated and/or hydrofluorocarbon chamber cleaning and etching gases. A significant difficulty with this approach is that these plasma processes have also exhibited incomplete conversions and poor selectivity.

Third, innovators have tried various approaches to recover, purify, and recycle the cleaning gases. For example, United States Patent 6,032,484 teaches a method for separation and recovery of fluorochemicals using membranes. A disadvantage of this approach is that the chamber effluent is highly diluted and a complex mixture of unconverted cleaning gases and very reactive by-products like molecular fluorine make abatement and recycle in this manner very difficult and inefficient.

United States Patent Application 2003/0056388 teaches that very high etch rates, efficient cleaning, and excellent process cost performance can be achieve with $F_2$-$SF_6$, $NF_3$-$SF_6$, and $O_2$-$SF_6$ mixtures. Unfortunately, only a fraction of the $SF_6$ feed is consumed in the process chamber and $SF_6$ has a very high global warming potential and is difficult to either destroy or recover and recycle.

Therefore, there remains a need in the art related to the efficient use of fluorochemicals in semiconductor processing techniques. There also remains a need to find cost-effective solutions for the problems noted above with respect to the prior art.

In a first aspect, the present invention provides a method of treating a gas output from a processing chamber, said gas including a less reactive fluorochemical and a more reactive fluorochemical, said method comprising:

a fluorination step wherein the concentration of said less reactive fluorochemical in said gas increases; and
a defluorination step wherein said more reactive fluorochemical is selectively removed from said gas.

In a second aspect, the present invention provides a method for the regeneration of a less reactive fluorochemical feed to a process chamber for the production of semiconductor devices using a more reactive fluorochemical in sequential fluorination and defluorination steps with the fluorination step operating at a temperature greater than $T_2$ for the more reactive fluorochemical and less than the lesser of $T_3$ or $T_4$ for the less reactive fluorochemical and the defluorination step utilizing a fluorine getter and operating at a temperature greater than $T_1$ for the more reactive fluor-

ochemical and less than $T_2$ for the less reactive fluorochemical.

Preferably, the method further comprises the steps of

determining a $T_1$ value for each said fluorochemical in said gas, said $T_1$ value being the temperature at which the first fluorine dissociation constant is equal to $10^{-22}$ atmospheres;

determining a $T_3$ value for each said fluorochemical in said gas, said $T_3$ value being the temperature at which about one percent of the fluorine is dissociated when the first fluorine dissociation constant is equal to $10^{-4}$ atmospheres assuming there are no disproportionation reactions;

determining a $T_4$ value for each said fluorochemical in said gas, said $T_4$ value being the temperature at which the Gibbs free energy of formation for the most stable reactants of said fluorochemical becomes positive; and

determining a $T_2$ value for each said fluorochemical in said gas, said $T_2$ value being the temperature at which the first fluorine dissociation constant is equal to $10^{-13}$ atmospheres;

In a third aspect, the present invention provides a method of treating a gas output from a processing chamber, said gas including a less reactive fluorochemical and at least one more reactive fluorochemical, said method comprising:

performing a fluorination operation on said gas to produce an intermediary gas, wherein at least a portion of said more reactive fluorochemical has been fluorinated and converted to said less reactive fluorochemical; and

performing a defluorination operation on said intermediary gas, wherein any said more reactive fluorochemical remaining after said fluorination operation is eliminated from said intermediary gas.

In a fourth aspect, the present invention can thus provide a method of regenerating a first fluorochemical feed gas from a gas output from a semiconductor process chamber, said gas containing said first fluorochemical and a second fluorochemical, wherein said first fluorochemical is less reactive than said second fluorochemical, said method comprising:

a fluorination step operating above a temperature at which said second fluorochemical is fluorinated and below a temperature at which said first fluorochemical remains stable; and

a defluorination step operating above a temperature at which said second fluorochemical begins fluorination and below a temperature at which said first fluorochemical experiences significant fluorination.

The present invention can thus provide a method for selecting, using, regenerating, and recycling fluorochemicals for plasma cleaning or etching steps in the production of semiconductor devices. This method comprises the selection of a regenerable fluorochemical working fluid and more active fluorochemicals, using the regenerable fluorochemical working fluid for chamber cleaning or etching, regenerating the fluorochemical working fluid with the more active fluorochemical in a two stage process comprising a sequential fluorination step and a subsequent defluorination step, and recovering and recycling the regenerated fluorochemical working fluid.

Preferred features of the present invention will now be described, by way of example only, with reference to the accompanying drawings, in which:

Figure 1 is a block flow diagram for a method of treating a gas output from a processing chamber;

Figure 2 is a simplified process flow diagram for a first example of the method; and

Figure 3 is a block flow diagram for a second example of the method.

The ideal chamber cleaning gas has a low reactivity at ambient temperature, is reasonably stable at elevated temperature, has low toxicity, and has low global warming potential. Table 1 summaries useful metrics to characterize fluorochemical etching and chamber cleaning gases and define recovery and recycle processes. The following discussion will consider each of these parameters.

Table 1:

| Fluorochemical Cleaning and Etching Gas Characterization Parameters | | | | | | |
|---|---|---|---|---|---|---|
| Specie | GWP[1] | TLV-ACGIH[2] ppm | Temperature, °C (see note 3 for $K_1$ definition) | | | |
| | | | $T_1$ ($K_1$=$10^{-22}$) | $T_2$ ($K_1$=$10^{-13}$) | $T_3$ ($K_1$=$10^{-4}$) | $T_4$ ($\Delta G$=0) |
| $NF_3$ | 10,090 | 10 | 171 | 363 | 844 | 672 |
| $CF_4$ | 6,500 | asphyxiant | 651 | 1034 | 1962 | >> 2000 |
| $ClF_3$ | low | very toxic | 45 | 113 | 231 | 74 |
| $CH_2F_2$ | 150 | 1000 | 590 | 952 | 1833 | always > 0 |
| $SF_6$ | 23,900 | 1000 | 384 | 648 | 1270 | >> 2000 |
| $F_2$ | low | 1 | 21 | 160 | 535 | always = 0 |

[1] 100 year global potential relative to $CO_2$ (weight basis)

[2] American Conference of Governmental Industrial Hygienists (ACGIH) ambient threshold limit values (TLVs)

[3] $K_1$ is the first fluorine atom dissociation equilibrium constant [$NF_3 \leftarrow \rightarrow NF_2(g) + F(g)$]

Many fluorochemicals have unusually long lifetimes in the atmospheres and unusually high infrared absorptivity, which leads to a very large impact on global warming. The global warming potential (GWP) is used to assess the relative impact of alternative gases on global warming due to infrared absorption over a 100 year timeframe relative to $CO_2$ using a weight comparison basis. For example, as set forth in Table 1, one gram of $NF_3$ would have roughly the same impact as 10,090 grams of $CO_2$. The fluorochemicals listed in Table 1 have a very broad range of global warming potential from less than $CO_2$ for $F_2$ and $ClF_3$ to 23,900 times the $CO_2$ global warming potential for $SF_6$.

The American Conference of Governmental Industrial Hygienists (ACGIH) has established ambient concentrations (ppm) threshold limit values (TLVs). Most workers can be repeatedly exposed to chemicals at the TLV day after day without adverse health effects. Therefore, the ACGIH-TLV value provides a useful measure of relative toxicity. An asphyxiant causes a health hazard by decreasing the oxygen content from about 21 to less than 19.5 volume percent, which would be equivalent to about 15,000 ppmv. As shown in Table 1, the ACGIH-TLV values for the listed fluorochemicals range from about 1 ppm for $F_2$ to about 15,000 ppmv (asphyxiant) for $CF_4$.

There is no widely accepted measure of fluorochemical fluorination reactivity. However, there is general agreement that the fluorine radical, F(g), is primarily responsible for the extraordinary reactivity of fluorochemicals under certain circumstances. Therefore, the first fluorine dissociation constant seems to provide a useful measure of the fluorochemical reactivity. The Outokumpu HSC Chemistry for Windows computer program (Version 4) provides a convenient method to estimate the first fluorine dissociation constant for a wide range of compounds. For example, for $NF_3$, the first dissociation reaction is $NF_3(g) \rightarrow NF_2(g) + F(g)$ and the first fluorine dissociation constant may be calculated from $K_{1,NF_3} = \dfrac{P_{NF_2} P_F}{P_{NF_3}}$, where $P_{NF_2}$, $P_F$, & $P_{NF_3}$ are the partial pressures in atmospheres of $NF_2(g)$, F(g), and $NF_3(g)$,

respectively. It has been found that temperatures at which the first fluorine dissociation constants ($K_1$) are equal to $10^{-22}$, $10^{-3}$, and $10^{-4}$ atmospheres ($T_1$, $T_2$, and $T_3$ respectively) provide useful measures of the fluorocarbon reactivity and guidance for selecting reactor operating conditions for the method described below. The value of $K_1$ for molecular fluorine at room temperature (about $10^{-22}$) provides a useful and familiar benchmark for a modest fluorination rate. $T_1$ values for other fluorochemicals (some as noted in Table 1) are then calculated based on the $K_1$ value of $10^{-22}$. Practical experience suggests that $K_1$ values of greater than about $10^{-13}$ result in fluorination rates that are appropriate for abatement processes for a wide variety of fluorochemical species. Therefore, $T_2$ provides an estimate of the temperature required to achieve adequate fluorination rates for a wide range of fluorochemicals and also provides a reasonable estimate for the minimum temperature for thermal abatement process. It should be noted that fluorocarbons with lower $T_2$ values have higher fluorination activity. The stability of the fluorochemical can then be assessed in two ways. $T_3$ is the temperature required for dissociating about one percent of the fluorochemical, assuming there are no disproportionation reactions. $T_4$ is the temperature at which the Gibbs free energy of formation for the specie, from the most stable reactants, become positive, which is a measure of the disproportionation tendency. For example, the most stable reactants for $CH_2F_2$ would be HF and carbon and the most stable reactants for $NF_3$ would be $N_2$ and $F_2$. $T_3$ and $T_4$ are used as measures of the maximum practical working fluorochemical temperature.

The data in Table 1 clearly shows a difficulty associated with selecting fluorochemical process chamber cleaning and etching gases. In particular, only relatively complex and expensive reagents like $CH_2F_2$ are stable, and have both reasonable toxicity and global warming potentials. The less costly reagents have varying problems. For example, some simple reagents are both highly toxic and very reactive, e.g. $ClF_3$ or $F_2$. Other fluorochemicals are stable but have high global warming potentials, e.g. $NF_3$, $SF_6$ or $CF_4$.

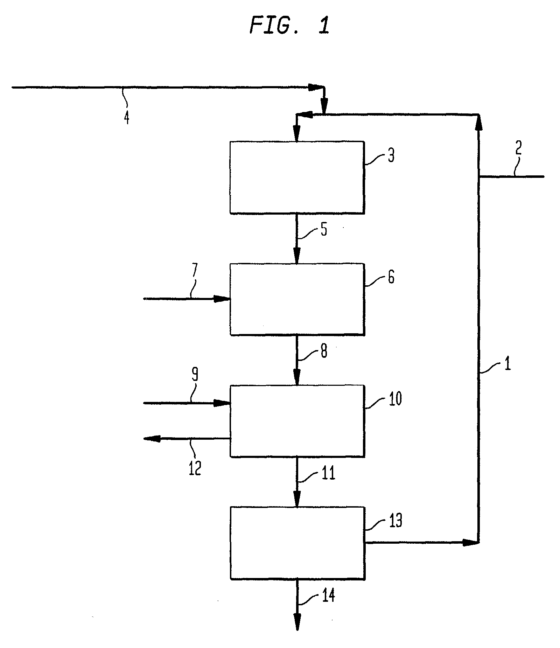

Figure 1 is a block flow diagram for a method of treating a gas from a processing chamber, wherein a combination of more reactive and less reactive fluorochemical gases is utilized. In particular, the less reactive fluorochemical gas is recycled for further use in, for example, a semiconductor manufacturing process, thus increasing the use efficiency of such gas, and reducing the impact of global warming potential emissions. Further, by recycling the less reactive fluorochemical gas, significant cost savings can be realized.

For purposes of the present invention, a fluorochemical is a chemical compound that contains one or more fluorine atoms. Less reactive fluorochemical gas means a gas having a higher $T_2$ value as compared with the more reactive fluorochemical gas. Preferably the $T_2$ value for the less reactive fluorochemical is at least 10°C greater than the $T_2$ value for the more reactive fluorochemical gas, more preferably at least 20°C higher, and most preferably at least 50°C higher.

As shown in Fig. 1, the recycled less reactive fluorochemical gas 1 is fed to a semiconductor process chamber 3. Less reactive fluorochemical gas or gases 2 may be added or removed to adjust for consumption or excess production of less reactive fluorochemical gas or gases 1. The less reactive fluorochemical gas may be a substantially pure fluorochemical, a mixture of fluorochemicals, or a mixture of fluorochemicals and non-fluorochemicals, usually inert gases like argon, nitrogen, or helium. The less reactive fluorochemical gas 1 or 2 must contain a non-fluorine atom and have a $T_4$ value that is greater than $T_2$. For example and referring to Table 1, $ClF_3$ can not be considered a less reactive fluorochemical gas because $T_2$ is greater than $T_4$. $F_2$ can not be considered a less reactive fluorochemical because it does not contain any non-fluorine bonds. $NF_3$ could be considered a less reactive fluorochemical relative to $F_2$ or $ClF_3$, but not relative to $CF_4$ or $SF_6$ because its $T_2$ value is less than the values of $T_2$ for $CF_4$ or $SF_6$. The less reactive fluorochemical 1 may be vaporized by subjecting the less reactive fluorochemical 1 to an elevated temperature or reduced pressure. A supplemental process chamber feed gas 4 can be added to the less reactive fluorochemical gas 1 prior to entering the process chamber 3 or fed directly to the process chamber 3. The supplemental feed gas 4 typically contains inert gases, e.g. argon, or helium, to help sustain the plasma and could contain other non-fluorochemical cleaning or etching gases, e.g. $N_2O$, $O_2$, $Cl_2$, or a more reactive fluorochemical gas, i.e. a gas with a $T_2$ value less than the major fluorochemical components of the less reactive fluorochemical gas 1. Alternatively, the process chamber supplemental feed gas 4 could contain components found in the less reactive fluorochemical gas 1 and serve to make-up for relatively small quantities that are lost or consumed in the semiconductor manufacturing process. A conventional remote plasma chamber may be used to subject the less reactive fluorochemical gas 1 and supplemental feed gas 4 to a plasma discharge either in the process chamber 3 or prior to entering the process chamber 3. The remote or process chamber plasma may also be used to produce the more reactive fluorochemical species from the less reactive gas and supplemental gas feed. For example, remote or process chamber plasmas could convert a feed comprising $SF_6$ and $O_2$ to more reactive fluorine radicals and molecular fluorine fluorochemical species in addition to the less reactive $SF_6$ fluorochemical. The process chamber 3 typically operates in various types of process steps; such as selective deposition of thin film layers and etching thin films to produce thin film transistor semiconductor devices. Periodically, the process chamber 3 must be cleaned to prevent contamination of the thin film layers with debris that inevitably accumulates on the process chamber walls. In this method, a combination of less reactive fluorochemical gas and more reactive fluorochemical gas is used for the cleaning operation. Alternatively, a mixture of less reactive fluorochemical gas and more reactive fluorochemical gas can be used for etching operations carried out in the process chamber 3. A conventional vacuum pump is used to increase the pressure of the process chamber 3 product gases to roughly atmospheric pressure. The method of the present invention further provides for regeneration of the less reactive fluorochemical gas from the off-gas 5 from the process chamber 3.

The gas output from the process chamber, or off-gas, 5 is typically a complex mixture of unreacted etching or cleaning gases, e.g. $CF_4$, $SF_6$, $O_2$, $F_2$, or $NF_3$; etching or cleaning by-products, e.g. $CF_4$, $CO_2$, $SiF_4$, or $AlF_3$; and fluorochemical decomposition products, e.g. $F_2$, $OF_2$, or $SO_xF_y$ where y is 1, 2, 3, or 4 and the sum of two times x and y is less than or equal to six. Many of the fluorochemical components in the off-gas 5 are highly reactive, toxic or have high global warming potentials. Therefore, it is desirable to covert the more problematic components of the off-gas 5 to other components that pose less risk or that can be recycled and reused in other processes carried out in the process chamber 3.

The off-gas 5 is subjected to a fluorination step 6 using either the more reactive fluorochemical species ($T_2$ values less than the $T_2$ values of the less reactive fluorochemical gas 1) of the process chamber off-gas 5 or optionally a fluorination step supplemental feed 7. The supplemental fluorination step feed 7 can be a non-hydrogen containing fuel, e.g. carbon, sulfur, $SO_2$ or $CS_2$, a sub-fluorinated fluorochemical, e.g. $SO_2F_2$, or more reactive fluorochemical, e.g. $F_2$ or $NF_3$. The fluorination step 6 operates at roughly the off-gas 5 pressure, usually about atmospheric pressure.

The fluorination step 6 preferred temperature is greater than $T_2$ for the more reactive fluorochemical components in the process chamber off-gas 5 and less than the lesser of $T_3$ or $T_4$ for the major components in the less reactive fluorochemical gas 1. The fluorination step 6 preferred temperature range may be achieved by indirect conduction heating, direct heating with an arc discharge, indirect inductive coupled heating, atmospheric pressure plasma discharge, exothermic reactions, e.g. $\frac{1}{2}S_2(g) + 3F_2(g) \rightarrow SF_6(g)$ or $SO_2 + 3F_2 \rightarrow SF_6 + O_2$, or other conventional heating means. However, combustion with a hydrogen containing fuel (hydrocarbon); may not be used to heat the off-gas 5. The fluorination step 6 is carried out within a closed reactor vessel with a feed and product gas connections. Metal packing may be advantageously added to the fluorination step reactor to increase the fluorination reaction and heat transfer rates. Nickel, Monel, and copper are preferred materials of construction for the fluorination step packing. In some cases, the process chamber off-gases 5 are fully appropriate feeds to the fluorination step 6. In these cases, no high temperature fluorination step supplemental feed 7 is required. The off-gas 5 and optional supplemental fluorination step feed 7 are contacted in fluorination step 6 until the very rapid fluorination reactions, e.g. $F_2(g) + SF_4(g) \rightarrow 2 SF_6$ (g), are essentially complete to produce the high temperature fluorination product gas 8. The gas residence time in the fluorination step 6 is preferably between 0.25 and 20 seconds, more preferably between 0.5 and 10 seconds, and most preferably between 1 and 5 seconds. The gas residence time is defined as the ratio of the fluorination step reactor void volume divided by the average total gas volumetric feed rate at the average fluorination step temperature and pressure. The fluorination step pressure is preferably between 0.5 and 3 atmospheres, more preferably between 0.75 and 2 atmospheres, most preferably about one atmosphere. By carrying out the fluorination step 6, some of the more reactive fluorochemicals gas in the process chamber off-gas 5 are converted to the preferred less reactive fluorochemical gas 1. Therefore, the product gas 8 contains a greater percentage of the less reactive fluorochemical gas 1, than the off-gas 5 and in particular more of the fluorochemical gas to be recycled.

The product gas 8 is then subjected to a defluorination step 10 using a fluorine atom getter 9 to selectively reduce the concentration of the more reactive fluorochemical components, e.g. $F_2$, $OF_2$, $SiF_4$, in the product gas 8. The operating pressure of the defluorination step 10 is preferable greater than 50%, more preferably greater than 75% and most preferably greater than 90% of the fluorination step. The preferred defluorination step 10 operating temperature is less than $T_2$ for the major fluorochemical components in the less reactive fluorochemical gas 1 and greater than $T_1$ for the more reactive fluorochemical gas. The gas residence time is adjusted to essentially completely convert the more reactive fluorochemicals with very little loss of the less reactive fluorochemical components in the less reactive fluorochemical gas 1. Preferably greater than 80%, more preferably greater than 90%, most preferably greater than 95% of the more reactive fluorochemical is removed with preferably less than 20%, more preferably less than 10%, most preferably less than 5% of the less reactive fluorochemical removed. The gas residence time in the defluorination step 7 is preferably between 0.1 and 10 seconds, more preferably between 0.5 and 5 seconds, and most preferably between 1 and 3 seconds. The fluorine atom getter 9 may be any material or combination of materials that can be easily separated from the low temperature fluorination product 11, reacts with fluorine radicals, e.g. F(g), or reactive components, e.g. $SiF_4$, at modest temperatures, and produces a useful fluorochemical product or a fluorochemical waste product that can be easily removed and conveniently discarded. For example, elemental sulfur or an ammonium hydrogen fluoride melt could be used as a fluorine atom getter 9 and produce $SF_6$ or $NF_3$ products, respectively which can be recycled and reused. Alternatively an alumina bed could be used as a fluorine atom getter 9 and produce an $AlF_3$ waste product, which would remain in the alumina bed for easy recovery as a low temperature fluorination step waste product 12, and $O_2$ which would be a component in the low temperature fluorination product 11. Alternatively, water or an aqueous solution could be used as the stream 9 feed for the defluorination step 10 to remove $F_2$, $SiF_4$, $SO_xF_y$ compounds by hydrolysis. The reactive nature of the fluorine radical provides many potential fluorine atom getter 9 options; including the use of a combination of fluorine atom getters or sequential use of fluorine atom getters. For example, one could sequentially contact the product gas 8 with sulfur, to produce $SF_6$, and then with alumina, to virtually eliminate the remaining more reactive fluorochemicals from low temperature fluorination product 11.

The defluorination product 11 is then subjected to a recycle fluorochemical recovery step 13 to recover the less reactive fluorochemical gas 1. Preferably, the defluorination product 11 is compressed to the distribution pressure of the less reactive fluorochemical gas 1, usually 2 to 5 atmospheres, and a cryogenic distillation is carried out to recover the less reactive fluorochemical gas 1 from the defluorination product 11. Any high freezing point components, e.g. $H_2O$ and HF, may be advantageously removed using an appropriate adsorbent, e.g. alumina prior to the distillation step.

The recovered less reactive fluorochemical gas 1 is recycled to the process chamber 3 for further semiconductor processing use. Distillation by-products 14 may be routed for further abatement, recycle or disposal as appropriate.

Manufacturers can determine the composition of off-gas 5 based upon the process being carried out in the process chamber 3 and the process gases utilized. With this in mind, key operating conditions, e.g. temperature, for the fluorination step 6 and the defluorination step 10 can be determined using the $T_2$ values for the fluorochemical components in the off-gas 5.

The following examples how the method operates, but are not intended to limit the scope of the present invention.

Example 1

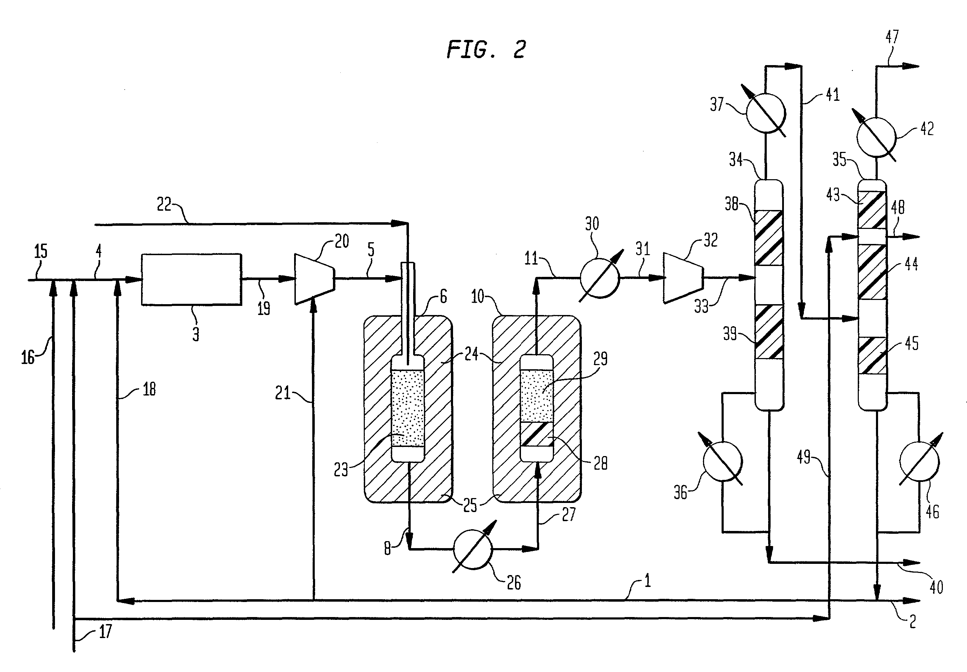

Figure 2 will be used to illustrate an example that uses a He-$NF_3$-$SF_6$-$O_2$ feed to process chamber 3 that is operating in the etch mode. The supplemental feed gas 4 is comprised of a helium feed 15, oxygen feed 16, and $NF_3$ feed 17. An $SF_6$ recycle gas feed 18 is either combined with the supplemental feed gas 4 or fed separately to the process chamber 3. Typical helium-to-$NF_3$, $SF_6$-to-$NF_3$, $O_2$-to-$NF_3$ process chamber 3 molar feed ratios are 12/1 and 6/1, and 0.5/1, respectively. The process chamber 3 operates at about 10 millibar using a microwave excitation source. The process chamber off-gas 19 is directed to a vacuum pump 20 to maintain the process chamber pressure and increase the off-gas pressure to about atmospheric pressure. A portion of the less reactive fluorochemical gas 21 may be advantageous used as ballast gas for the vacuum pump 20, replacing the conventional nitrogen. This is advantageously because the use of nitrogen as the ballast gas increases the operating pressure or reflux rate required to prevent freezing in the subsequent cryogenic purification system. The flow rate for the less reactive fluorochemical gas 21 is typically about 30% of the off-gas molar flow rate.

The vacuum pump off-gas 5 is fed to the fluorination step 6. Elemental sulfur 22 may optionally be fed to the high temperature fluorination step 6 to produce make-up $SF_6$. Alternatively, make-up $SF_6$ may be added to the supplemental feed gas 4. The fluorination step 6 is conducted in a vessel equipped with a copper or nickel reaction bed 23, electrical heater 24 and insulation 25. The fluorination step 6 uses molecular fluorine to produce $SF_6$ from less oxidized sulfur species in the off-gas 5. The process chamber 3 produced the fluorine reactants for the fluorination step 6 primarily from the $NF_3$ feed 17. As previously noted, the fluorination step 6 operating temperature is chosen to be greater than $T_2$ for the more reactive fluorochemical components of the off-gas 5 and less than the lesser of $T_3$ or $T_4$ for the less reactive components of off-gas 5. In this example, $F_2$ is the more reactive fluorochemical component and $SF_6$ and $NF_3$ are the less reactive fluorochemical components. Therefore, the appropriate temperature for the fluorination step 6 is between the $T_2$ value for $F_2$, e.g. about 200°C and the least of the $T_3$ or $T_4$ values for $SF_6$ or $NF_3$, e.g. about 500°C. The gas residence time should be about two seconds at this temperature to ensure essentially complete conversion of the $S_2F_{10}$, $SOF_2$, $SOF_4$ type species to $SF_6$.

The fluorination step product gas 8 is cooled to a temperature slightly less than the defluorination step 10 operating temperature in the fluorination step intercooler 26 to produce the defluorination step feed 27. The defluorination step 10 is conducted in a vessel equipped with a gas preheater bed 28, fluoride getter bed 29, electrical heater 24 and insulation 25. The gas preheater bed 28 enhances heat transfer in order to increase the gas temperature uniformity prior to contacting gases with an activated alumina fluoride getter bed 29. The fluoride getter bed 29 consumes essentially all the fluorine and other reactive components to concentrations less than 1000 ppm without significant conversion of $NF_3$ or $SF_6$. As previously noted, the operating temperature for the defluorination step 10 is less than the $T_2$ value for the less reactive fluorochemical components of the off-gas 5. In this example, the operating temperature should be less than the $T_2$ value for $NF_3$ or $SF_6$, e.g. between 100°C and 200°C. The gas residence time in the fluoride getter bed 29 should be about 2 seconds. The activated alumina fluoride getter bed material must be periodically replaced, and two fluoride getter beds 29 may be advantageously used, in countercurrent flow pattern with the defluorination step feed 27, to increase the utilization of fluoride getter without aversely affecting conversion.

Then the defluorination step product 11 is cooled in the fluorination step aftercooler 30. The cooled defluorination step product 31 is introduced into the distillation feed compressor 32 to increase the pressure to an appropriate distribution pressure and avoid freezing in the recycle fluorochemical recovery step using cryogenic distillation. The distillation feed gas 33 is compressed to between 2 and 8 bar. The recycle fluorochemical recovery step comprises a less volatile component removal column 34 and a more volatile component removal column 35. The less volatile component removal column 34 removes components in the distillation feed gas 33 that are less volatile, e.g. have lower vapor to liquid molar fraction ratios, than the less reactive fluorochemical gas 1. The less volatile component removal column 34 is a conventional cryogenic distillation column with a reboiler 36, knock-back condenser 37, rectifying section 38 and stripping section 39. Structured packing is preferably used to form the rectifying section 38 and stripping section 39, but conventional random packing or distillation trays could also be used. The reboiler 36 or knock-back condenser 37 heat duty is adjusted until an acceptable heavy component purge stream 40 is achieved and no freezing occurs in the less volatile component removal column 34 at the selected distillation feed compressor 32 outlet pressure. While either the reboiler 36 or knock-back condenser 37 heat duty is being adjusted to achieve the above product purity and column operability goals, the other duty is adjusted to maintain constant liquid inventory in the less volatile component removal column 34. The required reboiler 36 and knock-back condenser 37 heat duties and dimensions of the rectifying section 38, stripping section 39, reboiler 36 and knock-back condenser 37 can be estimated using standard techniques. The intermediate distillation stream 41 is the overhead product from the less volatile component removal column 34 and the feed to the more volatile component removal column 35. The more volatile component removal column 35 is also equipped with a knock-back condenser 42, upper rectifying section 43, lower rectifying section 44, stripping section 45 and reboiler 46. The knock-back condenser 42 is preferably operated at a temperature that is slightly greater than the $NF_3$ freezing point, e.g. about 66°K, to minimize the $NF_3$ loss in the light component purge stream 47. Typically, there is sufficient $NF_3$ in the intermediate distillation stream 41 to control the temperature and $NF_3$ inventory in the upper rectifying section 43 using the withdrawal rate of the crude $NF_3$ product 48 which may be used directly or purified before recycling to the process chamber 3. If there is insufficient $NF_3$ in the intermediate distillation stream 41, then the cryogenic distillation $NF_3$ feed 49 can be used to control the temperature and $NF_3$ inventory in the upper rectifying section 43. Structure packing is preferably used for the upper rectifying section 43, lower rectifying section 44 and stripping section 45 of the more volatile component removal column 35. After setting the knock-back condenser temperature, net crude $NF_3$ product 48 and cryogenic distillation $NF_3$ feed 49, the reboiler 46 heat duty is set to achieve the desired purity of the recycle less reactive fluorochemical gas 1. Conventional techniques can be used to establish reasonable dimensions for the knock-back condenser 42, upper rectifying section 43, lower rectifying section 44, stripping section 45 and reboiler 46. If the elemental sulfur feed exceeds process requirements, a $SF_6$-rich by-product fluorochemical gas 2 is produced. Valuable helium is concentrated in the light component purge stream 47 and may also be advantageously recovered.

Example 2

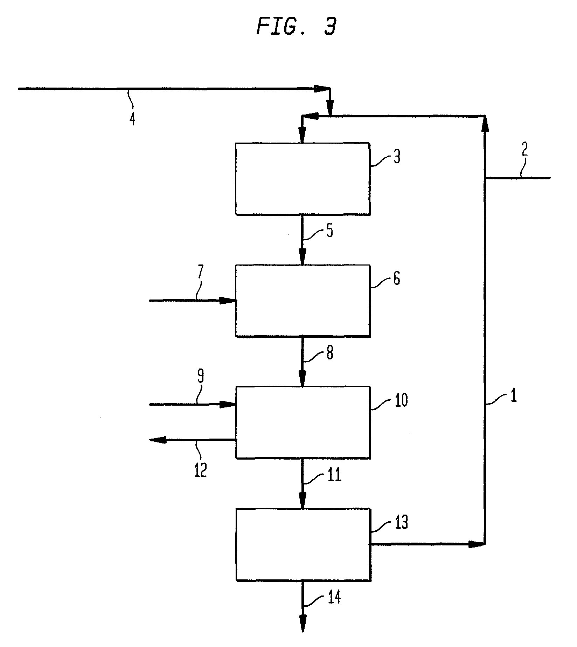

Figure 3 will be used for the second illustrative example for a chamber cleaning step. In this example, the supplemental gas 4 is substantially pure $O_2$ and the recycle less reactive fluorochemical gas 1 primary component is $SF_6$. A conventional remote plasma produces predominately a F, $F_2$, O, $SO_xF_y$, and $SF_6$ chamber cleaning gas to remove debris from the process chamber 3 walls. The expected process chamber off-gas 5 major components would include $SF_6$, $F_2$, $O_2$, $SiF_4$, HF, SOF, $SOF_2$, and $SO_2F_2$ in this case. Therefore, $F_2$ is the more reactive fluorochemical, $SF_6$ is the less reactive fluorochemical for recycle, and $SO_2F_2$ a less reactive waste product. Stream 5 is heated to about 500°C to convert substantially all the $SO_xF_y$ and $SF_z$ (z<6) species to $SF_6$ and $SO_2F_2$. Then, the resulting stream 8 is contacted in a conventional aqueous scrubber 9 with an aqueous stream 9 to remove any residual $F_2$, $SiF_4$, and a substantial portion of the $SO_xF_y$ species by hydrolysis via stream 11. Then, the $SF_6$ purification system 13 would first remove water from stream 11 using conventional technology and then produce the $SF_6$ recycle stream 1 and discard stream 14 by conventional distillation.

It is anticipated that other embodiments and variations of the present invention will become readily apparent to the skilled artisan in the light of the foregoing description and examples, and it is intended that such embodiments and variations likewise be included within the scope of the invention as set out in the appended claims.

**Claims**

1. A method of treating a gas output from a processing chamber, said gas including a less reactive fluorochemical and a more reactive fluorochemical, said method comprising:

   a fluorination step wherein the concentration of said less reactive fluorochemical in said gas increases; and
   a defluorination step wherein said more reactive fluorochemical is selectively removed from said gas.

2. A method according to claim 1, wherein said fluoronation step is carried out at a temperature greater than $T_2$ for said more reactive fluorochemical and less than the lesser of $T_3$ or $T_4$ for the less reactive fluorochemical and said defluorination step is carried out at a temperature greater than $T_1$ for the more reactive fluorochemical and less than $T_2$ for the less reactive fluorochemical.

3. A method according to claim 2, wherein $T_2$ of said less reactive fluorochemical is at least 10°C greater than $T_2$ of said more reactive fluorochemical.

4. A method according to claim 2, wherein $T_2$ of said less reactive fluorochemical is at least 20°C greater than $T_2$ of said more reactive fluorochemical.

5. A method according to claim 2, wherein $T_2$ of said less reactive fluorochemical is at least 50°C greater than $T_2$ of said more reactive fluorochemical.

6. A method according to any preceding claim, wherein said gas includes gases selected from the group consisting of $CF_4$, $SF_6$, $O_2$, $F_2$, $NF_3$, $ClF_3$, $CH_2F_2$, $CO_2$ $SiF_4$, $AlF_3$, $OF_2$, $SO_xF_y$ where y is 1, 2, 3 or 4 and 2(x) plus y is less than or equal to 6, and any combination thereof.

7. A method according to any preceding claim, wherein said less reactive fluorochemical is selected from the group consisting of $NF_3$, $SF_6$, $CF_4$ and combinations thereof and said more reactive fluorochemical is selected from the group consisting of $NF_3$, $CF_4$, $ClF_3$, $CH_2F_2$, $SF_6$, $F_2$ and combinations thereof.

8. A method according to claim 7, wherein said less reactive fluorochemical is $SF_6$, said more reactive fluorochemical is $NF_3$, said fluorination step operates at a temperature between about 360°C and 1270°C and said defluorination step operates at a temperature between about 170°C and 650°C.

9. A method according to claim 7, wherein said less reactive fluorochemical is $SF_6$, said more reactive fluorochemical is $F_2$, said fluorination step operates at a temperature between about 160°C and 1270°C and said defluorination step operates at a temperature between about 20°C and 650°C.

10. A method according to claim 7, wherein said less reactive fluorochemical is $NF_3$, said more reactive fluorochemical is $F_2$, said fluorination step operates at a temperature between about 160°C and 670°C and said defluorination step operates at a temperature between about 20°C and 360°C.

11. A method according to claim 7, wherein said gas includes a mixture of $SF_6$, $NF_3$, and $F_2$, and wherein said less reactive fluorochemical is $SF_6$, said more reactive fluorochemical is a mixture of $F_2$ and $NF_3$, said fluorination step operates at a temperature between about 360°C and 1270°C and said defluorination step operates at a temperature between about 170°C and 650°C.

12. A method according to claim 7, wherein said gas includes a mixture of $SF_6$, $NF_3$, and $F_2$, and wherein said less reactive fluorochemical is a mixture of $SF_6$ and $NF_3$, said more reactive fluorochemical is $F_2$, said fluorination step operates at a temperature between about 160°C and 670°C and said defluorination step operates at a temperature between about 20°C and 360°C.

13. A method according to any preceding claim, wherein said more reactive fluorochemical is produced, at least in part, from said less reactive fluorochemical in the process chamber.

14. A method according to any of Claims 1 to 12, wherein said more reactive fluorochemical is fed to the process chamber.

15. A method according to any of Claims 1 to 12, wherein said more reactive fluorochemical is fed to the fluorination step.

16. A method according to any preceding claim, further including the use of a metal packing in the fluorination step to increase either the rate of reaction or heat transfer, wherein said metal packing is selected from the group consisting of nickel, Monel, and copper.

17. A method according to any preceding claim, further including conducting said defluorination step in the presence of a fluorine getter selected from the group consisting of water, an aqueous solution, an activated alumina, elemental sulfur, and ammonium acid fluoride for $NF_3$ production.

18. A method according to any preceding claim, wherein said less reactive fluorochemical from said defluorination step is purified and provided to said process chamber.

19. A method according to claim 18, wherein less reactive fluorochemical is purified by cryogenic distillation.

20. A method according to any preceding claim, wherein said less reactive fluorochemical from said defluorination step is purified and utilized as ballast gas for a vacuum pump associated with said process chamber.

21. A method for the regeneration of a less reactive fluorochemical feed to a process chamber for the production of semiconductor devices using a more reactive fluorochemical in sequential fluorination and defluorination steps with the fluorination step operating at a temperature greater than $T_2$ for the more reactive fluorochemical and less than the lesser of $T_3$ or $T_4$ for the less reactive fluorochemical and the defluorination step utilizing a fluorine getter and operating at a temperature greater than $T_1$ for the more reactive fluorochemical and less than $T_2$ for the less

reactive fluorochemical.

22. A method of treating a gas output from a processing chamber, said gas including a less reactive fluorochemical and at least one more reactive fluorochemical, said method comprising:

performing a fluorination operation on said gas to produce an intermediary gas, wherein at least a portion of said more reactive fluorochemical has been fluorinated and converted to said less reactive fluorochemical; and performing a defluorination operation on said intermediary gas, wherein any said more reactive fluorochemical remaining after said fluorination operation is eliminated from said intermediary gas.

23. A method according to any of Claims 2 to 5, 21 and 22, further comprising the steps of

determining a $T_1$ value for each said fluorochemical in said gas, said $T_1$ value being the temperature at which the first fluorine dissociation constant is equal to $10^{-22}$ atmospheres; determining a $T_3$ value for each said fluorochemical in said gas, said $T_3$ value being the temperature at which about one percent of the fluorine is dissociated when the first fluorine dissociation constant is equal to $10^{-4}$ atmospheres assuming there are no disproportionation reactions; determining a $T_4$ value for each said fluorochemical in said gas, said $T_4$ value being the temperature at which the Gibbs free energy of formation for the most stable reactants of said fluorochemical becomes positive; and determining a $T_2$ value for each said fluorochemical in said off-gas, said $T_2$ value being the temperature at which the first fluorine dissociation constant is equal to $10^{-13}$ atmospheres;

24. A method according to claim 22 or 23, wherein said less reactive fluorochemical is $SF_6$.

25. A method of regenerating a first fluorochemical feed gas from a gas output from a semiconductor process chamber, said gas containing said first fluorochemical and a second fluorochemical, wherein said first fluorochemical is less reactive than said second fluorochemical, said method comprising:

a fluorination step operating above a temperature at which said second fluorochemical is fluorinated and below a temperature at which said first fluorochemical remains stable; and a defluorination step operating above a temperature at which said second fluorochemical begins fluorination and below a temperature at which said first fluorochemical experiences significant fluorination.

FIG. 1

*FIG. 2*

EP 1 531 190 A1

EP 1 531 190 A1

FIG. 3

13

EP 1 531 190 A1

## EUROPEAN SEARCH REPORT

European Patent Office

Application Number

EP 04 25 6984

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | US 6 322 756 B1 (ARNO JOSE I ET AL) 27 November 2001 (2001-11-27) * column 38, line 40 - line 65 * | 1-25 | C23C16/44 B01D53/68 |
| A | US 5 137 701 A (MUNDT ET AL) 11 August 1992 (1992-08-11) * claim 1 * | 1-25 | |
| A | US 5 750 823 A (WOFFORD ET AL) 12 May 1998 (1998-05-12) * claim 1 * | 1-25 | |

TECHNICAL FIELDS SEARCHED (Int.Cl.7)

C23C
B01D

The present search report has been drawn up for all claims

| Place of search | Date of completion of the search | Examiner |
|---|---|---|
| The Hague | 11 March 2005 | Faria, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

14

**EP 1 531 190 A1**

## ANNEX TO THE EUROPEAN SEARCH REPORT
## ON EUROPEAN PATENT APPLICATION NO.

EP 04 25 6984

This annex lists the patent family members relating to the patent documents cited in the above-mentioned European search report.
The members are as contained in the European Patent Office EDP file on
The European Patent Office is in no way liable for these particulars which are merely given for the purpose of information.

11-03-2005

| Patent document cited in search report | | Publication date | Patent family member(s) | | Publication date |
|---|---|---|---|---|---|
| US 6322756 | B1 | 27-11-2001 | US | 5955037 A | 21-09-1999 |
| | | | AU | 4817100 A | 21-11-2000 |
| | | | CN | 1359310 A | 17-07-2002 |
| | | | EP | 1198283 A1 | 24-04-2002 |
| | | | JP | 2002543957 T | 24-12-2002 |
| | | | WO | 0067879 A1 | 16-11-2000 |
| | | | JP | 2001502604 T | 27-02-2001 |
| | | | TW | 442842 B | 23-06-2001 |
| | | | WO | 9829181 A1 | 09-07-1998 |
| | | | US | 6333010 B1 | 25-12-2001 |
| | | | US | 2002018737 A1 | 14-02-2002 |
| US 5137701 | A | 11-08-1992 | EP | 0176295 A2 | 02-04-1986 |
| | | | JP | 61078423 A | 22-04-1986 |
| US 5750823 | A | 12-05-1998 | NONE | | |

For more details about this annex : see Official Journal of the European Patent Office, No. 12/82

15